(19) Europäisches Patentamt
European Patent Office
Office européen des brevets

(11) Veröffentlichungsnummer: **0 212 372 B1**

# (12) EUROPÄISCHE PATENTSCHRIFT

(45) Veröffentlichungstag der Patentschrift: **27.03.91**

(51) Int. Cl.5: **G03F 7/038**

(21) Anmeldenummer: **86110541.9**

(22) Anmeldetag: **30.07.86**

## (54) Photoreaktive Polymere für die Herstellung von Reliefstrukturen.

(30) Priorität: **03.08.85 DE 3527889**

(43) Veröffentlichungstag der Anmeldung:
**04.03.87 Patentblatt 87/10**

(45) Bekanntmachung des Hinweises auf die Patenterteilung:
**27.03.91 Patentblatt 91/13**

(84) Benannte Vertragsstaaten:
**BE CH DE FR GB IT LI NL SE**

(56) Entgegenhaltungen:
**EP-A- 0 164 100**

**CHEMICAL REVIEWS, vol. 73, no.3, May/June 1973, pages 255-281, American Chemical Society, Easton, PA., US; W.J. McKILLIP et al.: "The chemistry of aminimides"**

**CHEMICAL ABSTRACTS, vol. 79, no. 6, 13th August 1973, page 370, abstract no. 37032u, Columbus, Ohio, US; A. GILBERT: "Organic aspects of photochemistry. Photoreactions of compounds containing heteroatoms other than oxygen", & PHOTOCHEMISTRY 171, 2, 630-96**

(73) Patentinhaber: **BASF Aktiengesellschaft**
**Carl-Bosch-Strasse 38**
**W-6700 Ludwigshafen(DE)**

(72) Erfinder: **Schwalm, Reinhold, Dr.**
**Am Huettenwingert 53**
**W-6706 Wachenheim(DE)**
Erfinder: **Koch, Horst, Dr.**
**Schliffgasse 22**
**W-6711 Grosskarlbach(DE)**
Erfinder: **Schulz, Guenther, Dr.**
**Wasgaustrasse 24**
**W-6700 Ludwigshafen(DE)**
Erfinder: **Boettcher, Andreas, Dr.**
**Schlesier Strasse 17**
**W-6704 Mutterstadt(DE)**
Erfinder: **Loerzer, Thomas, Dr.**
**Carl-Bosch-Ring 2**
**W-6710 Frankenthal(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Rank Xerox (UK) Business Services

THE JOURNAL OF ORGANIC CHEMISTRY, vol. 35, no. 2, February 1970, pages 433-438, American Chemical Society, Easton, PA., US; A. BALASUBRAMANIAN et al.: "The photoisomerization of 1-iminopyridinium ylides to 1(1H), 2-diazepines"

BULLETIN DE LA SOCIETE CHIMIQUE DE FRANCE, no. 6, 1969, pages 2175-2180, Société Française de Chimie, Paris, FR; J. STREITH et al.: "No. 382 - Synthèse photochimique de (1-H)-Diazépines-1,2 III"

## Beschreibung

Die Erfindung betrifft photoreaktive Polymere mit N-Ylid-Strukturen von N-Heteroaromaten, die unter dem Einfluß von aktinischem Licht photochemische Struktur- und Eigenschaftsänderungen eingehen. Sie sind z.B. für die Strukturisierung von Leiterplatten oder Halbleiterbauelementen geeignet.

Photoreaktive Systeme für lithographische Verfahren sind bekannt. Neben Zweikomponentensystemen, die im allgemeinen aus einer filmbildenden Matrix und einer niedermolekularen photochemischen Komponente bestehen, sind auch photoreaktive Einkomponentensysteme, die photoreaktive und filmbildende Eigenschaften in einem Polymeren vereinen, bekannt. Verwiesen sei z.B. auf US-PS 4,389,482, US-PS 4,389,123 und DE-OS 21 50 691. Sie zeigen jedoch Nachteile, z.B. durch die erforderliche Mitverwendung organischer Lösungsmittel oder von alkalischen Lösungsmitteln bei dem Auftragen oder dem Entwickeln der Schichten.

Es ist auch bekannt, daß 1-Iminopyridinium-Ylide, die im Pyridin-Stickstoffatom z.B. Alkoxycarbonylimino-, Benzoylimino- oder Tosyliminogruppen enthalten, bei der Einwirkung von aktinischem Licht von etwa 320 nm Strukturänderungen, z.B. zu Diazepinen erfahren, wobei durch Elektronendonor-Substituenten wie Methyl-, Phenyl- oder Dimethylamino- Reste oder Halogenatome eine photoinduzierte Ringerweiterung begünstigt wird (vgl. J. Streith, Pure and Applied Chemistry, Vo. 49 (1977)) S. 305-315, H.-J. Timpe, Advances Heterocyclic Chem. Vol. 17 (1974), S. 213-253).

In der älteren, nicht vorveröffentlichten EP-A-0164100 sind bereits spezielle polymere Pyridinium-Ylide beschrieben, die unter Einwirkung von aktinischem Licht polymere N-Acyl-diazepine bilden, wodurch eine Änderung des hydrophilen/hydrophoben Eigenschaftsprofils der Polymeren bewirkt wird. Die in der EP-A-0164100 beschriebenen polymeren Pydridinium-Ylide enthalten Pyridinium-Ylid-Einheiten der Formeln

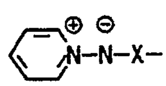

oder

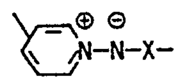

worin X:

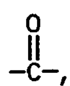,

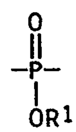

oder $-SO_2-$ und $R^1$: Alkyl, Aryl, Alkaryl oder Aralkyl bedeuten.

Aufgabe der vorliegenden Erfindung war es neue polymere photoreaktive Einkompensysteme mit hoher Photoreaktivität für die Herstellung von Reliefstrukturen zur Verfügung zu stellen, deren Eigenschaftsbild je nach Anwendungszweck in großem Umfang geändert werden kann und die bevorzugt filmbildende Eigenschaften zeigen.

Es wurde nun gefunden, daß diese Aufgabe durch photoreaktive Polymere gelöst werden kann, die im Polymeren Ylid-Gruppierungen von N-Heteroaromaten mit 6 Ringatomen und ein oder 2 (hetero)-aromatischen Ringen enthalten, insbesondere in einer Menge von 5 bis 50 Gewichtsprozent des Polymeren.

Besonderer Gegenstand der Erfindung sind photoreaktive Polymere, die unter dem Einfluß von aktinischem Licht photochemische Struktur- und Eigenschaftsänderungen eingehen, die dadurch kekennzeichnet sind, daß sie im Polymeren mesoionische Gruppierungen der Formel (I) enthalten

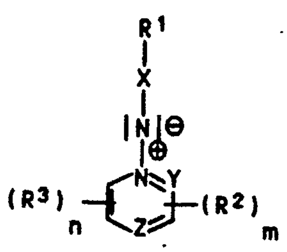

(I),

worin bedeuten:

Y und Z: $=CR^3-$ oder

Z: $=N-$ und Y: $=CR^3-$ oder

Y: =N- und Z: $=CR^3$-,
X: C=O, C=S, $>SO_2$,

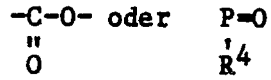

$R^1$: ein- oder zweiwertiger organischer Rest,
$R^2$: ein- oder zweiwertiger organischer Rest,
$R^3$: ein Wasserstoffatom oder ein organischer Rest, wobei zwei Reste $R^3$ gemeinsam einen aliphatischen, aromatischen oder heterocyclischen Ring bilden können,
$R^4$: ein organischer Rest, eine Hydroxylgruppe oder ein Halogenatom,
m: 0,1,2 oder 3,
n: 5-m, wenn Y und Z $=CR^3$- darstellen, und 4-m, wenn Y oder Z =N darstellt,
und die Gruppierungen I durch die Reste $R^1$, $R^2$ und/oder $R^3$ mit dem Polymerrest verbunden sind, wobei die Gruppierungen I Bestandteile der Polymerhaupt- und/oder -seitenketten sein können.

Im allgemeinen erhalten die erfindungsgemäßen Polymeren die Gruppierungen I in einer Menge von 5 bis 50 und insbesondere 5 bis 20 Gew.-% der Polymeren, stets in einer Menge, die bei der Belichtung mit aktinischem Licht eine Struktur- und Eigenschaftsänderung wie eine Änderung der Hydrophilie der Polymeren hervorruft.

Die Ylid-Strukturen der Gruppierungen I leiten sich besonders von N-Heteroaromaten ab wie Pyridin, Pyrazin, Chinolin oder Isochinolin, die in den aromatischen Kernen Substituenten tragen können.

Die Gruppierungen I können durch die Reste $R^1$, $R^2$ und/oder $R^3$, wenn diese zweiwertig sind, mit dem Polymerrest verbunden sein, wobei die Polymerkette in bekannter Weise eine Kohlenstoff- und/oder Heteroatome enthaltende Polymerkette sein kann.

Die Synthese der erfindungsgemäßen Polymeren kann nach an sich bekannten Methoden der makromolekularen Chemie durch Umsetzung einer Verbindung mit der Gruppierung der Formel I mit einer reaktiven Gruppierung im Rest $R^1$, $R^2$ und/oder $R^3$, z.B. einer Amino-, Hydroxyl-, Isocyanat- oder Säurechlorid-Gruppe mit einem Polymeren oder einer Verbindung erfolgen, das bzw. die Gruppierungen enthält, die mit der reaktiven Gruppierung im Rest $R^1$, $R^2$ und/oder $R^3$ sich umsetzt, wobei die Polyreaktionen Polykondensationen, Polyadditionen oder Polymerisationen sein können. Dabei lassen sich die Gruppierungen auch als wiederholte Bausteine in die Polymerhaupt-und -seitenketten einführen. Durch Polykondensations- bzw. Polyadditionsreaktionen von bi- und mehrfunktionellen Ylidbausteinen mit geeigneten Cobausteinen können Polymertypen wie Polyester, Polyurethane, Polyamide oder Polyharnstoffe hergestellt werden. Dafür geeignete Bausteine sind z.B. solche, die die Ylid-Gruppierung I enthalten und in mehr als einem der Reste $R^1$, $R^2$ und $R^3$ zwei gleiche oder unterschiedliche funktionelle Gruppen, wie -OH, $-NH_2$, -NCO, -COOH, -COCl, tragen, die mit sich selbst oder mit anderen geeigneten Bausteinen mit funktionellen Gruppen, z.B. Diisocyanaten, wie Bisphenol A-diisocyanat, Diolen wie Hexan-1,6-diol, Säuredichloriden wie Adipinsäure-dichlorid, p-Aminobenzoesäure etc. umgesetzt werden können.. Ein solches Polymeres hat z.B. die Struktur II:

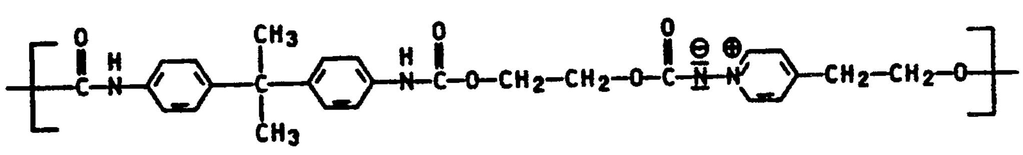 (II)

Polymere mit den Ylid-Gruppierungen I lassen sich aber auch durch Polymerisation oder Copolymerisationen von Monomeren der Formel I herstellen, die mindestens im Rest $R^1$ eine polymerisierbare oder copolymerisierbare aliphatische C-C-Doppel- oder Dreifachbindung enthalten, z.B. einen Vinyl-, Acryl- oder Methacrylrest. Bei der Homopolymerisation entstehen dann Homopolymerisate z.B. folgender Art:

(III) 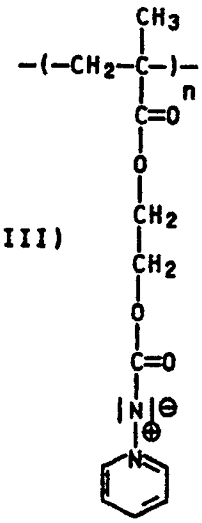

(IV) 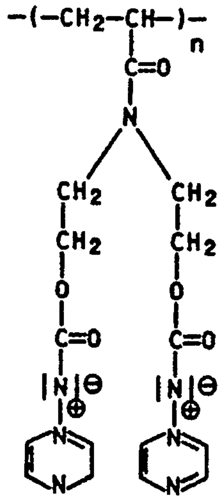

(V) 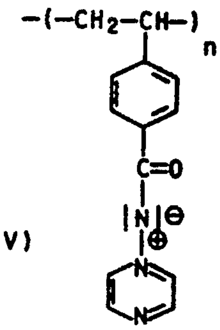

Bevorzugt sind Polymere, die durch Polymerisation oder Copolymerisation von Monomeren der Formel I hergestellt sind, worin $R^1$ ein einwertiger Rest und $R^2$ ein Rest mit mindestens einer polymerisierbaren oder copolymerisierbaren C-C-Doppel- oder Dreifachbindung ist. Beispiele sind Polymere, die durch Polymerisation oder Copolymerisation der nachfolgend aufgeführten Monomeren hergestellt sind:

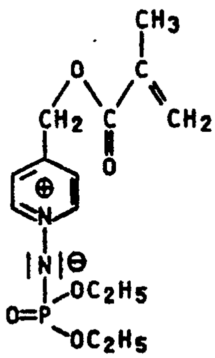 (VI)

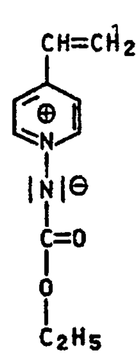 (VII)

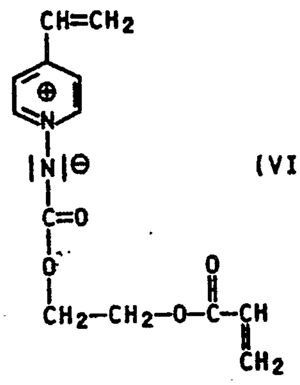

(VIII)

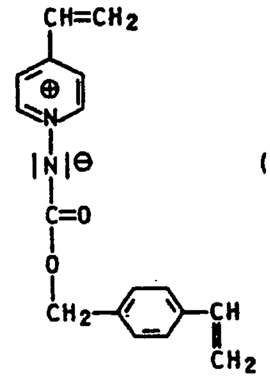

(IX)

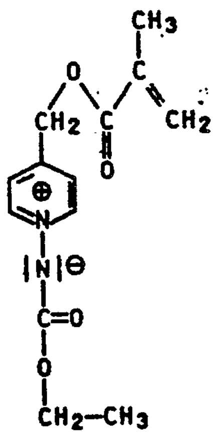

(X)

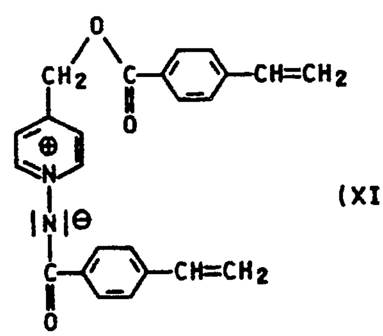

(XI)

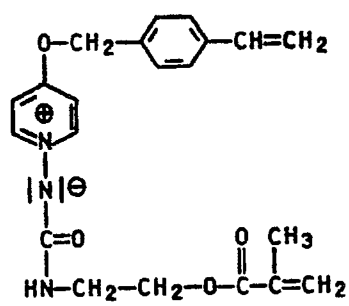

(XII)

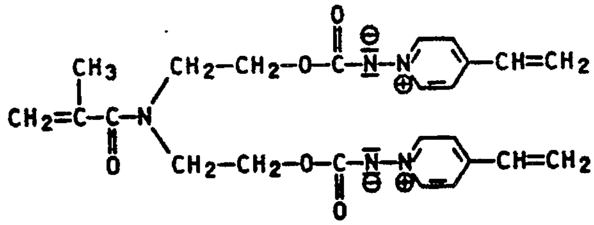

(XIII)

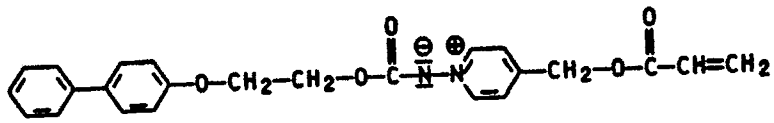

(XIV)

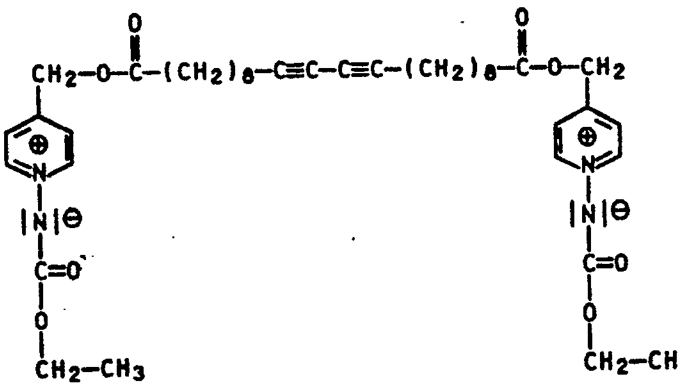

(XV)

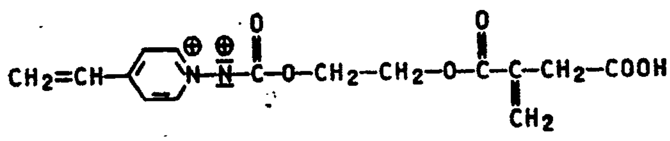

(XVI)

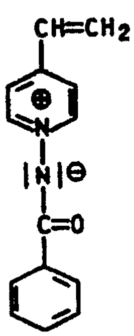

(XVII)

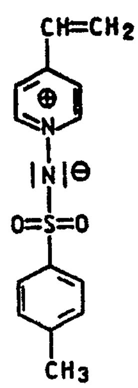

(XVIII)

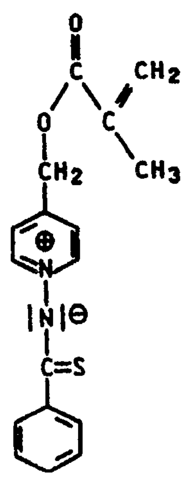

(XIX)

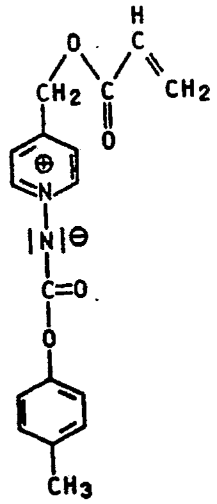

(XX)

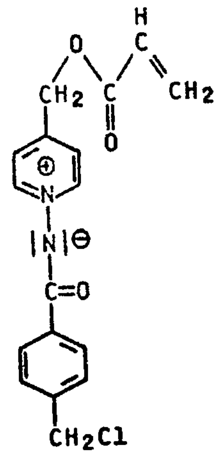

(XXI)

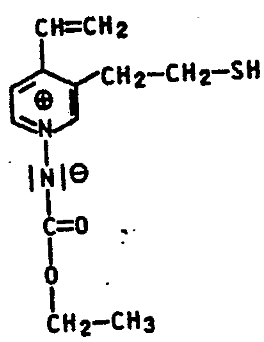

(XXII)

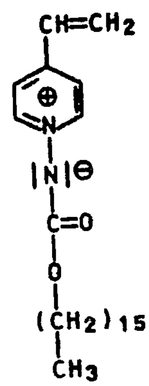

(XXIII)

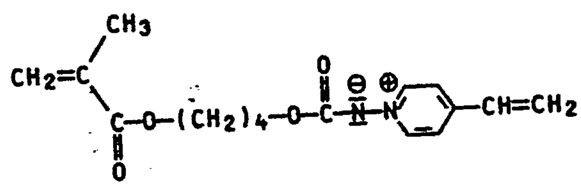

(XXIV)

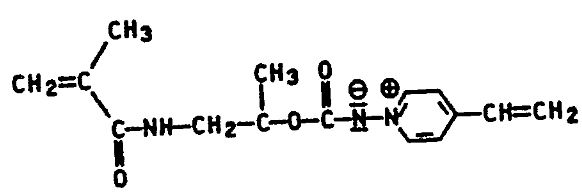

(XXV)

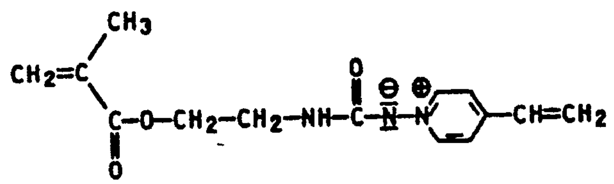

(XXVI)

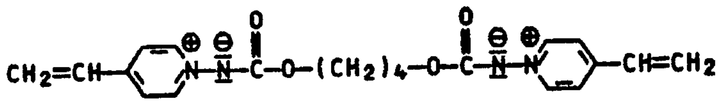

(XXVII)

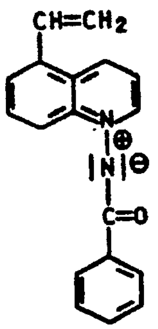

(XXVIII)

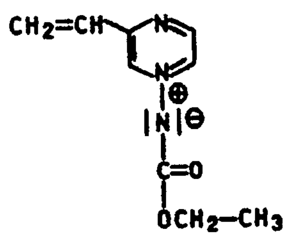

(XXIX)

Genannt seien auch Polymere, die wiederholt die folgenden Strukturen enthalten:

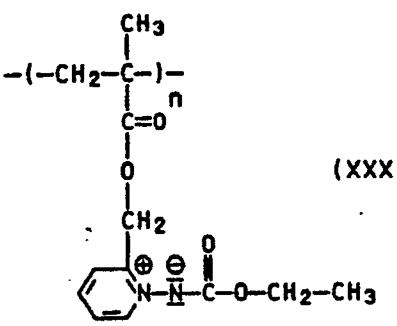

(XXX)

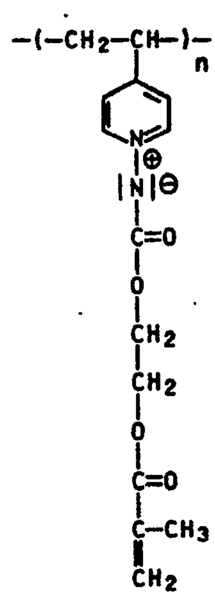

(XXXI)

Es lassen sich jedoch auch Polymerisate und Copolymerisate von Monomeren der Gruppierung I herstellen, die in dem Rest $R^1$, bevorzugt aber im Rest $R^2$ und/oder $R^3$ polymerisationsfähige Gruppen enthalten, z.B. Oxiran-Gruppen, die zu Polymeren führen, die z.B. wiederholt die Gruppierung I verbunden durch Ethylenoxid- oder Propylenoxid-Gruppen mit dem Polymerrest enthalten.

Beispiele weiterer (Co)Polymerer sind:

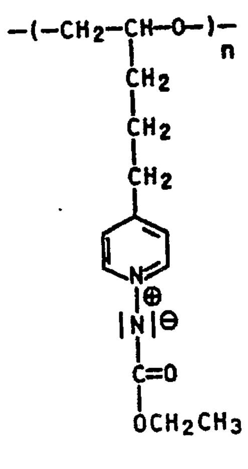

(XXXII)

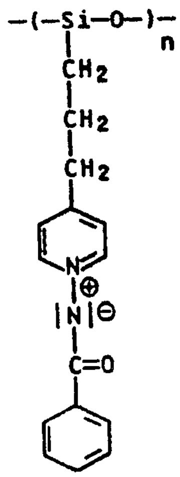

(XXXIII)

Insbesondere durch Copolymerisation von Monomeren der Gruppierung I, die im Rest $R^2$ oder $R^3$ Oxiran-Gruppen enthalten, mit z.B. Ethylenoxid oder Propylenoxid lassen sich Polymere unterschiedlicher hydrophiler Eigenschaften herstellen.

Als Comonomere der genannten Monomeren mit C-C-Doppel- oder Dreifachbindungen seien z.B. fluorhaltige Alkylacrylate, Styrol, Methylmethacrylat, Acrylnitril, Vinylacetat, Acrylamid, Butadien, Vinylpyridin, Vinylether, Methacrylat terminiertes Polystyrol etc. genannt, durch deren geeignete Auswahl sich die Eigenschaften der erfindungsgemäßen Polymeren den verschiedenen Anwendungszwecken gut anpassen lassen.

Erwähnt sei schließlich auch, daß die Gruppierung I auch durch an sich bekannte polymeranaloge Umsetzungen in ein Polymeres eingeführt werden kann, was eine zusätzliche Möglichkeit der Erzielung von Polymeren gewünschter Eigenschaften darstellt.

Bei Bestrahlung mit aktinischem Licht erfahren die erfindungsgemäßen Polymeren Struktur- und Eigenschaftsänderungen, die insbesondere eine erhebliche Differenzierung zwischen hydrophoben und hydrophilen Eigenschaften der bildmäßig bestrahlten Polymerschichten gestattet, ebenso eine Änderung von Haftungseigenschaften oder Grenzflächenaktivitäten bei der Anwendung.

Die bevorzugten Polymeren mit der Gruppierung I zeigen filmbildende Eigenschaften und lassen sich hervorragend nach bekannten Techniken zu sehr dünnen Filmen auf verschiedensten Substraten bzw. Trägern verarbeiten. Durch bildmäßiger Belichtung von solchen Polymerschichten mit aktinischem Licht sind Reliefstrukturen herstellbar. Die erfindungsgemäßen Polymeren sind besonders für die Strukturierung von Leiterplatten oder Halbleiterbauelementen geeignet.

Die Erfindung wird durch die nachstehenden Beispiele näher erläutert. Die in den Beispielen genannten Teile und Prozente beziehen sich, soweit nicht anders angegeben, auf das Gewicht. Volumenteile verhalten sich zu Teilen wie Liter zu Kilogramm.

Beispiel 1

Eine Lösung von 59 Teilen N-Amino-pyridinium-mesitylsulfonat in 1 200 Teilen Tetrahydrofuran wird mit 140 Teilen fein pulverisiertem Kaliumcarbonat versetzt, wobei eine violett-blaue Färbung entsteht. 39.3 Teile Ethylenglykolmonochlorformiat-monoacrylat in 100 Teilen Tetrahydrofuran werden dann so zugetropft, daß die blaue Färbung im Reaktionskolben erhalten bleibt. Die anorganischen Salze werden abfiltriert. Die organische Phase wird eingeengt, mit Dichlormethan verdünnt und mit wenig Natriumcarbonatlösung gewaschen. Nach dem Trocknen wird das Lösungmittel im Vakuum abgezogen. Es bleiben 33.5 Teile des Pyridinium-ylides zurück. Die Ausbeute beträgt 64 % d. Th. Im Dünnschichtchromatogramm ist die Substanz einheitlich.

2 Teile des Monomeren werden in 20 Teilen ausgekochtem deionisiertem Wasser gelöst. Die Lösung wird 2 Stdn. mit trockenem Stickstoff gespült, dann werden 0.002 Teile Azo-bis-isobernsteinsäure zugegeben und unter Überleitung von Stickstoff wird 24 Stdn. bei 60 °C polymerisiert.

Nach dem Abkühlen wird die Lösung in 200 Teile Tetrahydrofuran eingetropft. Das erhaltene Polymere wird im Vakuum getrocknet. Ausbeute: 0.5 Teile; IR-Spektrum und Elementaranalyse stimmen mit den erwarteten Werten überein. Das Polymere ist in Chloroform, Methanol und Wasser löslich und läßt sich leicht zu photoreaktiven Schichten verarbeiten.

Beispiel 2

Eine Lösung von 44.4 Teilen N-Amino-pyridinium-iodid in 1 200 Teilen Tetrahydrofuran werden mit 56 Teilen fein pulverisiertem Kaliumcarbonat versetzt, wobei eine violette Färbung entsteht. Bei 0 °C werden 32 Teile Isocyanatoethyl-methacrylat, in 100 Teilen Tetrahydrofuran gelöst, langsam zugetropft. Nach beendeter Zugabe wird noch 2 Stdn. bei Raumtemperatur gerührt und gemäß Beispiel 1 aufgearbeitet. Die Ausbeute betrug 69 % d.Th.

4 Teile des erhaltenen Monomeren werden in 50 Teilen trockenem alkoholfreiem Chloroform gelöst. Es wird 2 Stdn. mit trockenem Stickstoff gespült, dann werden 0,004 Teile Azobisisobutyronitril zugegeben und unter Überleitung von Stickstoff wird 24 Stdn. bei 60 °C polymerisiert. Anschließend werden nochmals 0.004 Teile Azobisisobutyronitril zugesetzt und weitere 8 Stdn. polymerisiert. Die Ausbeute an Polymerem betrug 2 Teile.

Beispiel 3

Eine Lösung für eine Beschichtung nach der sogenannten Spin-Coating-Technik wird hergestellt, indem man 0.5 Teile des in Beispiel 2 synthetisierten Polymeren in 5 Teilen Methylglykol löst. Die Lösung wird durch ein 0.2 1m-Filter filtriert. Etwa 0.6 Volumenteile dieser Lösung werden auf ein Siliciumsubstrat gebracht und bei ca. 3000 U/min aufgeschleudert. Es ergibt sich eine Filmdicke von etwa 0.45 µm. Die lichtempfindliche Schicht wird sodann unter Verwendung einer Quecksilber-Hochdrucklampe belichtet. Die Belichtung durch eine Maske wird 1 min. fortgesetzt. Die Lichtintensität bei 365 nm beträgt etwa 5 $mW/cm^2$. Durch Entwickeln mit deionisiertem Wasser während 30 s erhält man eine gut ausgebildete Reliefstruktur.

Beispiel 4

10.5 Teile Poly-4-vinylpyridin werden in 70 Volumenteilen einer Mischung aus Wasser/Methanol im Volumenverhältnis 9/1 gelöst. Hierzu tropft man eine Lösung, die wie folgt hergestellt wurde: 11.3 Teile Hydroxylamin-O-sulfonsäure wurden in 40 Volumenteilen Wasser gelöst, auf 0 °C abgekühlt und mit 30 Volumenteilen 20%iger wäßriger Kalilauge neutralisiert.

Die Mischung wird 3 Stunden bei 70 °C gerührt, auf die Hälfte des Volumens eingeengt und durch Filtration von anorganischen Niederschlägen befreit. Das resultierende Filtrat wird zum Trocknen eingeengt. Der Rückstand wird in Chloroform gelöst, mit 20 Teilen fein gepulverter Pottasche versetzt und anschließend mit 10.85 Teilen Ethylchloroformiat umgesetzt. Anschließend wird die Lösung filtriert und das Filtrat in Ligroin ausgefällt. Das resultierende Polymer wurde abfiltriert und mehrfach mit Ligroin gewaschen.

## Ansprüche

1. Photoreaktive Polymere, die durch Bestrahlen mit aktinischem Licht ihre Struktur und Eigenschaften ändern, dadurch gekennzeichnet, daß sie Gruppierungen der Formel I enthalten,

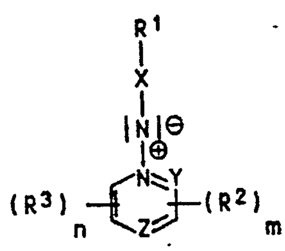

(I)

worin bedeuten:
Y und Z: $=CR^3$- oder
Z: =N- und Y: $=CR^3$- oder
Y: =N- und Z: $=CR^3$,
X: C=O, C=S, $SO_2$,

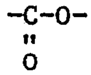 oder 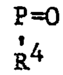

$R^1$: ein- oder zweiwertiger organischer Rest,
$R^2$: ein- oder zweiwertiger organischer Rest,
$R^3$: ein Wasserstoffatom oder ein organischer Rest, wobei zwei Reste $R^3$ gemeinsam einen aliphatischen, aromatischen oder heterocyclischen Ring bilden können,
$R^4$: ein organischer Rest, eine Hydroxylgruppe oder ein Halogenatom,
m: 0,1,2 oder 3,
n: 5-m, wenn Y und Z $=CR^3$- darstellen, und 4-m, wenn y oder Z =N-darstellt,
und die Gruppierungen 1 durch die Reste $R^1$, $R^2$ und/oder $R^3$ mit dem Polymerrest verbunden sind, wobei die Gruppierungen I Bestandteile der Polymerhaupt- und/oder -seitenketten sein können, mit der Maßgabe, daß für den Fall, daß Y und Z: $=CR^3$- mit $R^3$: einem Wasserstoffatom oder einem einfachen organischen Rest, ohne daß zwei Reste $R^3$ unter Bildung eines aliphatischen, aromatischen oder heteroaromatischen Ringes miteinander verbunden sind, darstellen, X nur C=S,

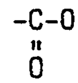

oder

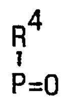

mit $R^4$: einer Hydroxylgruppe oder einem Halogenatom bedeutet.

**2.** Photoreaktive Polymere gemäß Anspruch 1, dadurch gekennzeichnet , daß sie Gruppierungen der Formel I in einer Menge von 5 bis 50 Gew.-% enthalten.

**3.** Photoreaktive Polymere gemäß Anspruch 1 oder 2, dadurch gekennzeichnet , daß die Gruppierungen der Formel I Pyridinium-Ylide, Pyrazinium-Ylide, Chinolinium-Ylide oder Isochinolinium-Ylide sind, die in den aromatischen Ringen Substituenten tragen können.

**4.** Photoreaktive Polymere gemäß Anspruch 1 oder 2, dadurch gekennzeichnet , daß Y und Z: $=CR^3$- bedeuten.

**5.** Photoreaktive Polymere gemäß Anspruch 1 oder 2, dadurch gekennzeichnet , daß Y: $=CR^3$- und Z: =N- bedeuten.

**6.** Photoreaktive Polymere gemäß einem der Ansprüche I bis 5, dadurch ge kennzeichnet , daß zwei Reste $R^3$ gemeinsam einen aromatischen Ring bilden.

**7.** Photoreaktive Polymere gemäß einem der Ansprüche 1 bis 6, dadurch ge kennzeichnet , daß die Gruppierungen der Formel I ausschließlich durch einen zweiwertigen Rest $R^2$ an eine Polymerhauptkette gebunden sind und $R^1$ einen einwertigen Rest darstellt.

**8.** Photoreaktive Polymere gemäß einem der Ansprüche 1 bis 6, dadurch ge kennzeichnet , daß sie die Gruppierungen der Formel I als Bestandteil eines wiederkehrenden Bausteins eines Polyaddats oder Polykondensats enthalten.

**9.** Photoreaktive Polymere gemäß einem der Ansprüche 1 bis 6, dadurch ge kennzeichnet , daß sie durch Polymerisation oder Copolymerisation von Monomeren der Formel I hergestellt sind, worin $R^1$ ein einwertiger organischer Rest und $R^2$ ein Rest mit mindestens einer polymerisierbaren und/oder copolymerisierbaren C-C-Doppel- oder Dreifachbindung ist.

**10.** Photoreaktive Polymere gemäß Anspruch 9, dadurch gekennzeichnet, daß das Monomere im Rest $R^2$ eine Acryl- oder Methacrylgruppierung enthält.

**11.** Photoreaktive Polymere gemäß einem der Ansprüche 1 bis 5, dadurch gekennzeichnet, daß sie durch Polymerisation oder Copolymerisation von Monomeren der Formel I hergestellt sind, worin $R^1$ ein einwertiger organischer Rest und m = 0 ist und mindestens ein Rest $R^3$ ein Rest mit mindestens einer polymerisierbaren und/oder copolymerisierbaren C-C-Doppel- oder Dreifachbindung ist.

**12.** Photoreaktive Polymere gemäß einem der Ansprüche 1 bis 11, dadurch gekennzeichnet, daß sie filmbildend und in Wasser oder alkalisch wäßrigen Lösungen löslich sind.

**13.** Reliefstrukturen, die durch Bestrahlen von Schichten von photoreaktiven Polymeren gemäß einem der Ansprüche 1 bis 12 mit aktinischem Licht und nachfolgendes Entwickeln derselben hergestellt sind.

Patentansprüche für folgende Vertragsstaaten : CH, NL, LI

**1.** Photoreaktive Polymere, dadurch gekennzeichnet, daß sie im Polymeren Ylid-Gruppierungen von N-Heteroaromaten mit 6 Ringatomen und ein oder zwei aromatischen bzw. heteroaromatischen Ringen enthalten, die durch Bestrahlen mit aktinischem Licht ihre Struktur und Eigenschaften ändern.

**2.** Photoreaktive Polymere gemäß Anspruch 1, die durch Bestrahlen mit aktinischem Licht ihre Struktur und Eigenschaften ändern, dadurch gekennzeichnet, daß sie Gruppierungen der Formel I enthalten,

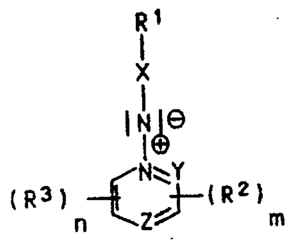

(I)

worin bedeuten:

Y und Z: $=CR^3$- oder

Z: =N- und Y: $=CR^3$- oder

Y: =N- und Z: $=CR^3$,

X: C=O, C=S, $SO_2$,

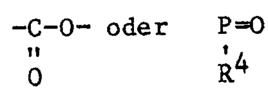

$R^1$: ein- oder zweiwertiger organischer Rest,

$R^2$: ein- oder zweiwertiger organischer Rest,

$R^3$: ein Wasserstoffatom oder ein organischer Rest, wobei zwei Reste $R^3$ gemeinsam einen aliphatischen, aromatischen oder heterocyclischen Ring bilden können,

$R^4$: ein organischer Rest, eine Hydroxylgruppe oder ein Halogenatom,

m: 0,1,2 oder 3,

n: 5-m, wenn Y und Z $=CR^3$- darstellen, und 4-m, wenn Y oder Z =N-darstellt,

und die Gruppierungen I durch die Reste $R^1$, $R^2$ und/oder $R^3$ mit dem Polymerrest verbunden sind, wobei die Gruppierungen I Bestandteile der Polymerhaupt- und/oder -seitenketten sein können.

**3.** Photoreaktive Polymere gemäß Anspruch 1 oder Anspruch 2, dadurch gekennzeichnet, daß sie die Ylid-Gruppierungen bzw. Gruppierungen der Formel I in einer Menge von 5 bis 50 Gew.-% enthalten.

**4.** Photoreaktive Polymere gemäß Anspruch 1 oder Anspruch 2, dadurch gekennzeichnet, daß die Ylid-Gruppierungen bzw. Gruppierungen der Formel I Pyridinium-Ylide, Pyrazinium-Ylide, Chinolinium-Ylide oder Isochinolinium-Ylide sind, die in den aromatischen Ringen Substituenten tragen können.

5. Photoreaktive Polymere gemäß Anspruch 2, dadurch gekennzeichnet, daß Y und Z: $=CR^3$- bedeuten.

6. Photoreaktive Polymere gemäß Anspruch 2, dadurch gekennzeichnet, daß Y: $=CR^3$- und Z: =N- bedeuten.

7. Photoreaktive Polymere gemäß Anspruch 2, dadurch gekennzeichnet, daß zwei Reste $R^3$ gemeinsam einen aromatischen Ring bilden.

8. Photoreaktive Polymere gemäß Anspruch 2, dadurch gekennzeichnet, daß die Gruppierungen der Fortmel I ausschließlich durch einen zweiwertigen Rest $R^2$ an eine Polymerhauptkette gebunden sind und $R^1$ einen einwertigen Rest darstellt.

9. Photoreaktive Polymere gemäß Anspruch 1 oder Anspruch 2, dadurch gekennzeichnet, daß es die Ylid-Gruppierungen bzw. Gruppierungen der Formel I als Bestandteil eines wiederkehrenden Bausteins eines Polyaddats oder Polykondensats enthält.

10. Photoreaktive Polymere gemäß Anspruch 2, dadurch gekennzeichnet, daß sie durch Polymerisation oder Copolymerisation von Monomeren der Formel I hergestellt sind, worin $R^1$ ein einwertiger organischer Rest und $R^2$ ein Rest mit mindestens einer polymerisierbaren und/oder copolymerisierbaren C-C-Doppel- oder Dreifachbindung ist.

11. Photoreaktive Polymere gemäß Anspruch 10, dadurch gekennzeichnet, daß das Monomere im Rest $R^2$ eine Acryl- oder Methacrylgruppierung enthält.

12. Photoreaktive Polymere gemäß Anspruch 2, dadurch gekennzeichnet, daß sie durch Polymerisation oder Copolymerisation von Monomeren der Formel I hergestellt sind, worin $R^1$ ein einwertiger organischer Rest und m = 0 ist und mindestens ein Rest $R^3$ ein Rest mit mindestens einer polymerisierbaren und/oder copolymerisierbaren C-C-Doppel- oder Dreifachbindung ist.

13. Photoreaktive Polymere gemäß Anspruch 1 oder Anspruch 2, dadurch gekennzeichnet, daß sie filmbildend und in Wasser oder alkalisch wäßrigen Lösungen löslich sind.

14. Reliefstrukturen, die durch Bestrahlen von Schichten von photoreaktiven Polymeren gemäß Anspruch 1 oder Anspruch 2 mit aktinischem Licht und nachfolgendes Entwickeln derselben hergestellt sind.

## Claims

1. A photoreactive polymer which changes its structure and properties as a result of exposure to actinic light, wherein said polymer contains groups of the formula I

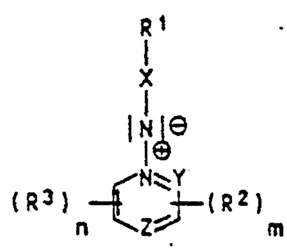

(I)

where
Y and Z are each $=CR^3$- or
Z is =N- and Y is $=CR^3$- or
Y is =N- and Z is $=CR^3$,
X is CO, C=S, $SO_2$,

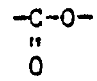 or 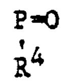 ,

$R^1$ and $R^2$ are each a monovalent or divalent organic radical,
$R^3$ is hydrogen or an organic radical, and two radicals $R^3$ together may form an aliphatic, aromatic or heterocyclic ring,
$R^4$ is an organic radical, hydroxyl or halogen,
m is 0, 1, 2 or 3 and
n is 5-m when Y and Z are each $=CR^3$- and is 4-m when y or Z is =N-,
and the groups I are bonded to the polymer radical by the radicals $R^1$, $R^2$ and/or $R^3$ and may be part of the polymer main and/or side chains, with the proviso that, when Y and Z are each $=CR^3$- where $R^3$ is hydrogen or a simple organic radical without two radicals $R^3$ being bonded to one another with formation of an aliphatic, aromatic or heteroaromatic ring, X is only C=S, or, where $R^4$ is hydroxyl or halogen.

2. A photoreactive polymer as claimed in claim 1, which contains groups of the formula I in an amount of from 5 to 50% by weight.

3. A photoreactive polymer as claimed in claim 1 or 2, wherein the groups of the formula I are pyridinium ylides, pyrazinium ylides, quinolinium ylides or isoquinolinium ylides, which may carry substituents in the aromatic rings.

4. A photoreactive polymer as claimed in claim 1 or 2, wherein Y and z are each $=CR^3$-.

5. A photoreactive polymer as claimed in claim 1 or 2, wherein y is $=CR^3$- and Z is =N-.

6. A photoreactive polymer as claimed in any of claims 1 to 5, wherein two radicals $R^3$ together form an aromatic ring.

7. A photoreactive polymer as claimed in any of claims 1 to 6, wherein the groups of the formula I are bonded to the polymer main chain exclusively by a divalent radical $R^2$, and $R^1$ is a monovalent radical.

8. A photoreactive polymer as claimed in any of claims 1 to 6, which contains the groups of the formula I as part of a repeating building block of a polyadduct or polycondensate.

9. A photoreactive polymer as claimed in any of claims 1 to 6, which are prepared by polymerization or copolymerization of monomers of the formula I, where $R^1$ is a monovalent organic radical and $R^2$ is a radical having one or more polymerizable and/or copolymerizable C-C double or triple bonds.

10. A photoreactive polymer as claimed in claim 9, wherein the monomer contains an acryl or methacryl group in the radical $R^2$.

11. A photoreactive polymer as claimed in any of claims 1 to 5, which is prepared by polymerization or copolymerization of monomers of the formula I where $R^1$ is a monovalent organic radical and m is 0 and one or more radicals $R^3$ are radicals having one or more polymerizable and/or copolymerizable C-C double or triple bonds.

12. A photoreactive polymer as claimed in any of claims 1 to 11, which is film-forming and is soluble in water or aqueous alkaline solutions.

13. A relief structure which is produced by exposing layers of photoreactive polymers as claimed in any of claims 1 to 12 to actinic light and then developing said layers.

Claims for the following Contracting States : CH, NL, LI

1. A photoreactive polymer which contains ylide groups of N-heteroaromatics having 6 ring atoms and one or two aromatic or heteroaromatic rings in the polymer and which changes its structure and properties

as a result of exposure to actinic light.

2. A photoreactive polymer as claimed in claim 1 which changes its structure and properties as a result of exposure to actinic light, wherein said polymer contains groups of the formula I

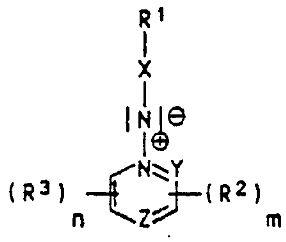

(I)

where
Y and Z are each $=CR^3$- or
Z is $=N$- and Y is $=CR^3$- or
Y is $=N$- and Z is $=CR^3$,
X is $C=O$, $C=S$, $SO_2$,

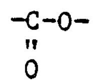 or 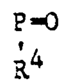 ,

$R^1$ and $R^2$ are each a monovalent or divalent organic radical,
$R^3$ is hydrogen or an organic radical, where two radicals $R^3$ together may form an aliphatic, aromatic or heterocyclic ring,
$R^4$ is an organic radical, hydroxyl or halogen,
m is 0, 1, 2 or 3, and
n is 5-m when Y and Z are each $=CR^3$- and is 4-m when Y or Z is $=N$-,
and the groups I are bonded to the polymer radical by the radicals $R^1$, $R^2$ and/or $R^3$ and may be part of the polymer main and/or side chains.

3. A photoreactive polymer as claimed in claim 1 or claim 2, which contains the ylide groups or groups of the formula I in an amount of from 5 to 50% by weight.

4. A photoreactive polymer as claimed in claim 1 or claim 2, wherein the ylide groups or groups of the formula I are pyridinium ylides, pyrazinium ylides, quinolinium ylides or isoquinolinium ylides, which may carry substituents in the aromatic rings.

5. A photoreactive polymer as claimed in claim 2, wherein Y and Z are each $=CR^3$-.

6. A photoreactive polymer as claimed in claim 2, wherein Y is $=CR^3$- and Z is $=N$-.

7. A photoreactive polymer as claimed in claim 2, wherein two radicals $R^3$ together form an aromatic ring.

8. A photoreactive polymer as claimed in claim 2, wherein the groups of the formula I are bonded to the polymer main chain exclusively by a divalent radical $R^2$, and $R^1$ is a monovalent radical.

9. A photoreactive polymer as claimed in claim 1 or claim 2, which contains the ylide groups or groups of the formula I as part of a repeating building block of a polyadduct or polycondensate.

10. A photoreactive polymer as claimed in claim 2, which is prepared by polymerization or copolymerization of monomers of the formula I, where $R^1$ is a monovalent organic radical and $R^2$ is a radical having one or more polymerizable and/or copolymerizable C-C double or triple bonds.

11. A photoreactive polymer as claimed in claim 10, wherein the monomer contains an acryl or methacryl group in the radical $R^2$.

12. A photoreactive polymer as claimed in claim 2, which is prepared by polymerization or copolymerization of monomers of the formula I where $R^1$ is a monovalent organic radical and m is 0 and one or more radicals $R^3$ are radicals having one or more polymerizable and/or copolymerizable C-C double or triple bonds.

13. A photoreactive polymer as claimed in claim 1 or claim 2, which is film-forming and is soluble in water or aqueous alkaline solutions.

14. A relief structure which is produced by exposing layers of photoreactive polymers as claimed in claim 1 or claim 2 to actinic light and then developing said layers.

## Revendications

1. Polymères photoréactifs dont la structure et les propriétés sont modifiées par l'exposition à la lumière actinique, caractérisés en ce qu'ils contiennent des groupements de formule I

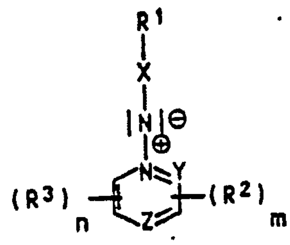

(I)

dans laquelle
Y et Z représentent $=CR^3$- ou bien
Z représente =N- et Y représente $=CR^3$- ou bien
Y représente =N- et Z représente $=CR^3$-,
X représente C=O, C=S, $SO_2$,

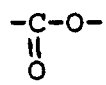 ou 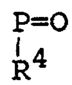

$R^1$ représente un radical organique mono- ou divalent,
$R^2$ représente un radical organique mono- ou divalent,
$R^3$ représente un atome d'hydrogène ou un radical organique, deux des substituants $R^3$ pouvant former ensemble un cycle aliphatique, aromatique ou hétérocyclique,
$R^4$ représente un radical organique, un groupe hydroxy ou un atome d'halogène,
m est égal à 0, 1, 2 ou 3,
n est égal à 5-m lorsque Y et Z représentent $=CR^3$- , et à 4-m lorsque Y ou Z représente =N-,
et les groupements I sont reliés au reste du polymère par les substituants $R^1$, $R^2$ et/ou $R^3$, les groupements I pouvant être constituants de la chaîne principale et/ou des chaînes latérales du polymère, sous réserve que dans le cas où Y et 2 représentent $=CR^3$- et $R^3$ représente un atome d'hydrogène ou un radical organique simple, sans que deux substituants $R^3$ soient reliés entre eux avec formation d'un cycle aliphatique, aromatique ou hétéroaromatique, X ne peut représenter que C=S,

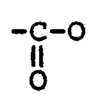

ou

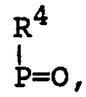

$R^4$ représentant un groupe hydroxy ou un atome d'halogène.

2. Polymères photoréactifs selon la revendication 1, caractérisés en ce qu'ils contiennent les groupements de formule I en quantités de 5 à 50 % en poids.

3. Polymères photoréactifs selon la revendication 1 ou 2, caractérisés en ce que les groupements de formule I sont des ylides de pyridinium, des ylides de pyrazinium, des ylides de quinoléinium ou d'isoquinoléinium qui peuvent porter des substituants sur les noyaux aromatiques.

4. Polymères photoréactifs selon la revendication 1 ou 2, caractérisés en ce que Y et Z représentent $=CR^3-$.

5. Polymères photoréactifs selon la revendication 1 ou 2, caractérisés en ce que Y représente $=CR^3-$ et Z représente $=N-$.

6. Polymères photoréactifs selon l'une des revendications 1 à 5, caractérisés en ce que deux substituants $R^3$ forment ensemble un cycle aromatique.

7. Polymères photoréactifs selon l'une des revendications 1 à 6, caractérisés en ce que les groupements de formule I sont reliés à une chaîne principale du polymère exclusivement par l'intermédiaire d'un radical divalent $R^2$, et $R^1$ représente un radical monovalent.

8. Polymères photoréactifs selon l'une des revendications 1 à 6, caractérisés en ce qu'ils contiennent les groupements de formule I en tant que constituants d'un motif répété d'un polyadduct ou d'un polycondensat.

9. Polymères photoréactifs selon l'une des revendications 1 à 6, caractérisés en ce qu'ils sont préparés par polymérisation ou copolymérisation de monomères de formule I dans laquelle $R^1$ représente un radical organique monovalent et $R^2$ un radical contenant au moins une double liaison ou triple liaison C-C polymérisable et/ou copolymérisable.

10. Polymères photoréactifs selon la revendication 9, caractérisés en ce que le monomère contient dans le groupe $R^2$ un groupement acrylique ou méthacrylique.

11. Polymères photoréactifs selon l'une des revendications 1 à 5, caractérisés en ce qu'ils sont préparés par polymérisation ou copolymérisation de monomères de formule I dans laquelle $R^1$ représente un radical organique monovalent et $m = 0$, et au moins un symbole $R^3$ représente un radical contenant au moins une double liaison ou triple liaison C-C polymérisable et/ou copolymérisable.

12. Polymères photoréactifs selon l'une des revendications 1 à 11, caractérisés en ce qu'ils sont filmogènes et solubles dans l'eau ou dans les solutions aqueuses alcalines.

13. Structures en relief, formées par exposition à la lumière actinique de couches de polymères photoréactifs selon l'une des revendications 1 à 12 et développement subséquent de ces couches.

Revendications pour les Etats contractants suivants : CH, NL, LI

1. Polymères photoréactifs, caractérisés en ce qu'ils contiennent des groupements ylides de composés N-hétéroaromatiques à 6 atomes cycliques et 1 ou 2 cycles aromatiques ou hétéroaromatiques, dont la structure et les propriétés sont modifiées par l'exposition à la lumière actinique.

2. Polymères photoréactifs selon la revendication 1, dont la structure et les propriétés sont modifiées par l'exposition à la lumière actinique, caractérisés en ce qu'ils contiennent des groupements de formule I

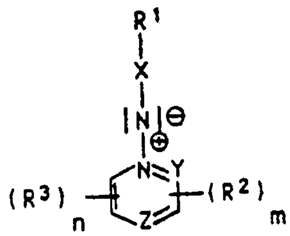

(I)

dans laquelle
Y et Z représentent $=CR^3$- ou bien
Z représente =N- et Y représente $=CR^3$- ou bien
Y représente =N- et Z représente $=CR^3$-,
X représente C=O, C=S, $SO_2$,

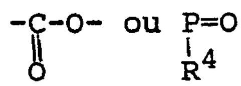

$R^1$ représente un radical organique mono- ou di-valent,
$R^2$ représente un radical organique mono- ou di-valent,
$R^3$ représente un atome d'hydrogène ou un radical organique, deux substituants $R^3$ pouvant former en commun un noyau aliphatique, aromatique ou hétérocyclique,
$R^4$ représente un radical organique, un groupe hydroxy ou un atome d'halogène,
m est égal à 0, 1, 2 ou 3,
n est égal à 5-m lorsque Y et Z représentent $=CR^3$- et à 4-m lorsque Y ou Z représente =N-,
et les groupements I sont reliés au reste du polymère par l'intermédiaire des substituants $R^1$, $R^2$ et/ou $R^3$, les groupements I pouvant être constituants de la chaîne principale et/ou de chaînes latérales du polymère.

**3.** Polymères photoréactifs selon la revendication 1 ou 2, caractérisés en ce qu'ils contiennent les groupements ylides ou groupements de formule I en quantités de 5 à 50 % en poids.

**4.** Polymères photoréactifs selon la revendication 1 ou 2, caractérisés en ce que les groupements ylides ou groupements de formule I sont des ylides de pyridinium, des ylides de pyrazinium, des ylides de quinoléinium ou des ylides d'isoquinoléinium pouvant porter des substituants sur les noyaux aromatiques.

**5.** Polymères photoréactifs selon la revendication 2, caractérisés en ce que Y et Z représentent $=CR^3$-.

**6.** Polymères photoréactifs selon la revendication 2, caractérisés en ce que Y représente $=CR^3$- et Z représente = N-.

**7.** Polymères photoréactifs selon la revendication 2, caractérisés en ce que deux substituants $R^3$ forment ensemble un noyau aromatique.

**8.** Polymères photoréactifs selon la revendication 2, caractérisés en ce que les groupements de formule I sont reliés à une chaîne principale du polymère exclusivement par l'intermédiaire d'un radical divalent $R^2$, et $R^1$ représente un radical monovalent.

**9.** Polymères photoréactifs selon la revendication 1 ou 2, caractérisés en ce qu'ils contiennent les groupements ylides ou groupements de formule I en tant que constituants d'un motif répété d'un polyadduct ou d'un polycondensat.

**10.** Polymères photoréactifs selon la revendication 2, caractérisés en ce qu'ils sont préparés par polymérisation ou copolymérisation de monomères de formule I dans laquelle $R^1$ représente un radical organique monovalent et $R^2$ un groupe contenant au moins une double liaison ou triple liaison C-C polymérisable et/ou copolymérisable.

**11.** Polymères photoréactifs selon la revendication 10, caractérisés en ce que le monomère contient un groupement acrylique ou méthacrylique dans le groupe $R^2$.

**12.** Polymères photoréactifs selon la revendication 2, caractérisés en ce qu'ils sont préparés par polymérisation ou copolymérisation de monomères de formule I dans laquelle $R^1$ représente un radical organique monovalent et m = 0, et l'un au moins des symboles $R^3$ représente un radical contenant lui-même au moins une double liaison ou triple liaison C-C polymérisable et/ou copolymérisable.

**13.** Polymères photoréactifs selon la revendication 1 ou 2, caractérisés en ce qu'ils sont filmogènes et solubles dans l'eau ou dans les solutions aqueuses alcalines.

**14.** Structures en relief formées par exposition à la lumière actinique de couches de polymères photoréactifs selon la revendication 1 ou 2 et développement subséquent de ces couches.